# EUROPEAN PATENT APPLICATION

(11) **EP 3 699 958 A1**
(43) Date of publication of application: **26.08.2020**
(21) Application number: 19158215.4
(22) Date of filing: 20.02.2019
(51) Int. Cl.: H01L 23/495, H01L 23/498, H01L 25/07, C22C 9/00

(54) **ELECTRONIC CHIP RELIABLY MOUNTED WITH COMPRESSIVE STRAIN**

(71) Applicant: Infineon Technologies AG, 85579 Neubiberg (DE)
(72) Inventor: Roth, Alexander, 93197 Zeitlarn (DE)
(74) Representative: Dilg, Haeusler, Schindelmann Patentanwaltsgesellschaft mbH

(57) **Abstract**

An electronic component (100) which comprises a carrier (102) and an electronic chip (104) mounted with compressive strain on the carrier (102), wherein at least a part of a material of the carrier (102) fulfils at least two of the following three criteria: an offset yield point Rₚ₀₂ in a range between 100°C and 300°C is at least 300 N/mm²; a yield strength in a range between 100°C and 300°C is at least 250 N/mm²; an electrical conductivity at 20°C is at least 65% of the International Annealed Copper Standard IACS.

## Description

### Background

### Technical Field

Various embodiments relate generally to an electronic component, and to a method of manufacturing an electronic component.

### Description of the related art

A conventional package may comprise an electronic chip mounted on a chip carrier such as a leadframe, may be electrically connected by a bond wire extending from the chip to the chip carrier, and may be molded using a mold compound.

### Summary

There may be a need to provide an electronic component having a high reliability.

According to an exemplary embodiment, an electronic component is provided which comprises a carrier, and an electronic chip mounted with compressive strain on the carrier, wherein at least a part of a material of the carrier fulfils at least two of the following three criteria: an offset yield point Rₚ₀₂ in a range between 100°C and 300°C is at least 300 N/mm²; a yield strength in a range between 100°C and 300°C is at least 250 N/mm²; an electrical conductivity at 20°C is at least 65% of the International Annealed Copper Standard IACS.

According to another exemplary embodiment, a method of manufacturing an electronic component is provided, wherein the method comprises mounting an electronic chip with compressive strain on a carrier, and providing at least a part of a material of the carrier so as to fulfil at least two of the following three criteria: an offset yield point Rₚ₀₂ in a range between 100°C and 300°C is at least 300 N/mm²; a yield strength in a range between 100°C and 300°C is at least 250 N/mm²; an electrical conductivity at 20°C is at least 65% of the International Annealed Copper Standard IACS.

According to an exemplary embodiment, an electronic component (such as a package or module) is provided in which an electronic chip (such as a semiconductor die) is mounted on a carrier so that an intentionally maintained compressive strain or compressive stress of the electronic chip created as a result of the manufacturing procedure can be maintained over a long period of time and can be maintained even when there is a high ratio between semiconductor area and carrier area. It has been surprisingly found that meeting two or all three of three material parameters of material of the carrier may allow obtaining an electronic component with a long-term reliable maintenance of compressive strain of a mounted electronic chip even when the semiconductor area of the chip has a relatively high value in relation to the surface area of the carrier. More specifically, an offset yield point or proof stress of at least 300 N/mm² in combination with a yield strength of at least 250 N/mm², an offset yield point of at least 300 N/mm² in combination with an electric conductivity of at least 65% IACS, a yield strength of at least 250 N/mm² in combination with an electric conductivity of at least 65% of IACS, or even an offset yield of at least 300 N/mm² in combination with a yield strength of at least 250 N/mm² and in combination with an electrical conductivity of at least 65% IACS may allow obtaining this goal. The mentioned combination of parameters may ensure a sufficiently permanent rigid property of the carrier material, while simultaneously enabling a proper conductance of electric signals or current.

Hence, an exemplary embodiment may make it possible to improve the performance of the electronic component by enabling long-term or even life-time compressive strain of a semiconductor-type electronic chip. This may be particularly advantageous for multi-chip devices (i.e. an electronic component having a plurality of electronic chips mounted on the carrier) with stiff die attach, i.e. implementing a connection structure (such as a solder structure or a sinter structure) between carrier and chip(s) having stiff material properties.

### Description of further exemplary embodiments

In the following, further exemplary embodiments of the electronic component and the method will be explained.

In the context of the present application, the term "electronic component" may particularly denote a package comprising one or more electronic chips packaged using one or more assembly units. Optionally, also an encapsulant and/or one or more electrically conductive contact elements (such as bond wires or clips) may be implemented in an electronic component.

The term "electronic chip" may particularly denote a semiconductor chip having at least one integrated circuit element (such as a diode or a transistor) in a surface portion thereof. The electronic chip may be a naked die or may be already packaged or encapsulated. In particular, the electronic chip may be a power semiconductor chip.

In the context of the present application, the term "carrier" may particularly denote an electrically conductive structure which serves as a support for the one or more electronic chips, and which may also contribute to the electric interconnection between the electronic chip (s) and the periphery. In other words, the carrier may fulfil a mechanical support function and an electric connection function.

In the context of the present application, the term "mounted with compressive strain" (or compressive stress) may particularly denote the fact that the electronic chip may be mounted (for instance by soldering or sintering) on the carrier at a mounting temperature being sufficiently high (in particular at least 300°C, more particularly at least 320°C, preferably above 350°C) so that by a subsequent temperature reduction of the fixedly mounted electronic chip to an operation temperature (for instance in a range between -30°C and +80°C) the different coefficients of thermal expansion of the material of the electronic chip (in particular predominantly made of a semiconductor material such as silicon) on the one hand and carrier material (for instance a copper zirconium alloy) on the other hand may result in the generation of compressive stress in the electronic chip. In other words, the electronic chip (in particular semiconductor chip) may be under compressive stress when mounted on the carrier. When establishing a stiff connection structure between electronic chip and carrier, it may be possible to permanently maintain compressive strain of the electronic chip fixed on the carrier. Mounting an electronic chip with compressive strain or stress may have a positive impact on the bandwidth properties of the semiconductor material of the electronic chip and may therefore be desired.

In the context of the present application, the term "offset yield point Rₚ₀₂" or proof stress may particularly denote a stress at which 0.2% plastic deformation occurs. The offset yield point may be defined as a value of 0.2% plastic strain.

In the context of the present application, the term "yield strength" or yield stress may particularly denote the material property defined as the stress at which a material begins to deform plastically. A yield point may be denoted as the point where nonlinear (elastic plus plastic) deformation begins.

In the context of the present application, the term "International Annealed Copper Standard IACS" may particularly denote an empirically derived standard value for the electrical conductivity of commercially available copper. This value corresponds to an electrical conductivity of 58x10⁶ S/m at 20 C. This standard may be used as a comparative property in the specification of the conductivity of metals or alloys. For example, the conductivity of a particular material may be specified as 75% IACS, meaning that its electrical conductivity is 75% of the copper specified as the IACS standard.

In one embodiment, an offset yield point Rₚ₀₂ in a range between 100°C and 300°C is at least 300 N/mm² (in particular at least 420 N/mm²), and a yield strength in a range between 100°C and 300°C is at least 250 N/mm² (in particular at least 350 N/mm²). In another embodiment, an offset yield point Rₚ₀₂ in a range between 100°C and 300°C is at least 300 N/mm² (in particular at least 420 N/mm²), and an electrical conductivity at 20°C is at least 65% of the International Annealed Copper Standard IACS. In still another embodiment, a yield strength in a range between 100°C and 300°C is at least 250 N/mm² (in particular at least 350 N/mm²), and an electrical conductivity at 20°C is at least 65% of the International Annealed Copper Standard IACS. Preferably, all three of the above defined criteria may be fulfilled for said material of the carrier.

In an embodiment, the material of the carrier which fulfils at least two of said three criteria may be a material or constituent (for instance layer) of the carrier located closest to the electronic chip, in particular a material of the carrier being separated from the electronic chip only by a stiff connection structure (such as a solder structure or a sinter structure).

In an embodiment, the offset yield point Rₚ₀₂ in a range between 100°C and 300°C is at least 500 N/mm². With such a high value of the offset yield point, the reliability of the electronic component and in particular the long-term maintenance of the compressive strain of the mounted electronic chip can be further improved.

In an embodiment, the yield strength in a range between 100°C and 300°C is at least 500 N/mm². When the yield strength has such a high value, the robustness and reliability of the electronic component mounted under compressive stress can be further enhanced.

In an embodiment, the electrical conductivity at 20°C is at least 75% of the International Annealed Copper Standard IACS. With such a high electrical conductivity, both the electrical and the mechanical reliability of the electronic component may be improved, and also a proper thermal performance may be obtained. Since the mechanisms of conducting electric current and conducting heat are physically in many cases closely related, such a high electric conductivity can also contribute to the removal of heat during operation of the package or electronic component.

In an embodiment, the material comprises or consists of at least one of the group consisting of a metal and an alloy. Thus, in particular the portion of the material of the carrier being closest to the electronic chip may be metallic or of alloy type. When such a metal or alloy meets at least two of the three above-defined criteria, a proper reliability and long-term maintenance of the compressive strain of the electronic chip may be ensured.

In an embodiment, the material comprises or consists of an alloy of copper with not more than one weight percent of at least one other metal, in particular zirconium and/or chromium and/or silver and/or zinc. The amount of one weight percent is to be understood in relation to the weight of the copper and the at least one other metal together. In other words, a ratio between the weight of the at least one metal divided by a sum of the weight of the copper and the weight of the at least one metal is preferably not more than one percent. Descriptively speaking, the mentioned only small additional metallic constituent (in addition to copper) of not more than one weight percent ensures that the copper lattice is only disturbed in a moderate way to maintain the high electric conductivity of copper while suppressing copper material from flowing in the presence of mechanical load or stress.

In an embodiment, the material comprises or consists of a copper-X alloy, in particular comprises or consists of primarily copper and up to one weight percent of X, X being a sum of zirconium, chromium, silver and zinc (wherein X may relate to one material or any combination of materials of the group of zirconium, chromium, silver and zinc).

More specifically, the material may comprise or consist of a copper-zirconium alloy, in particular comprises or consists of CuZr (preferably CuZr0.1), or comprises or consists of CuCrZr (preferably CuCr0.1Zr). This alloy is also known as "CW106C" according to DIN EN 17670 (in particular in the most recent version at the priority date of the present application). It has turned out that copper zirconium alloys, in which copper is the major or main component, may act as high performance material with an excellent yield strength. Although already alloys composed of copper and zirconium only provide proper results, it has also been found that copper chromium zirconium alloys comprising an additional contribution of chromium also yield excellent properties supporting the long-term maintenance of compressive strain of the electronic chip. A proper value of the yield strength is obtainable with the mentioned materials in particular in a particularly relevant temperature range between 100°C and 300°C. Thus, the mentioned materials qualify perfectly for the carrier of the electronic component, or part thereof.

Other alternative materials exist in the form of copper-silver and copper-zinc alloys, which also show the desired properties. Copper-Silver and its common derivates are described in DIN EN 1976 und DIN EN 1977, standardized in DIN EN 13599 and known as CW013A. Copper-Zinc is standardized in DIN CEN/TS 13388, DIN EN 1652 and known as CW119C. Other binary alloys with low additions are also feasible (CuMg0.1, CuFe0.1, CuSn0.15), as well as trinary alloys using combinations of the mentioned additions as well as P. All mentioned standards may relate in particular to their most recent version at the priority date of the present application.

In an embodiment, the material of the carrier has an overall (or average or net) coefficient of thermal expansion (CTE) of larger than 10 ppm/K (in particular at 20°C), in particular larger than 14 ppm/K (in particular at 20°C). With such high CTE values of the carrier material in comparison with lower CTE values of the chip material (for instance silicon has a CTE value of about 3 ppm/K), a proper CTE mismatch between the carrier and the electronic chip becomes possible, in particular when the electronic chip is a semiconductor die. Such a pronounced CTE mismatch may ensure a high compressive strain of the electronic chip when stiffly mounted on the carrier. This may, in turn, result in advantageous properties in terms of switching loss, etc. Thus, the mentioned CTE values are particularly advantageous for switching applications using power semiconductor chips.

In an embodiment, the carrier is a bare metal body (for instance may be made of pure metal (s)). In other words, it may be advantageous if the carrier consists only of one or more metallic materials. This may have a positive impact on yield strength as well as electric conductivity.

In an embodiment, the carrier is a leadframe, in particular a bare metal leadframe. Such a leadframe may be a sheet-like metallic structure which can be patterned so as to form one or more mounting sections for mounting one or more electronic chips of the package or electronic component, and one or more lead sections for electric connection of the package or electronic component to an electronic environment when the electronic chip(s) is/are mounted on the leadframe. In an embodiment, the leadframe may be a metal or alloy plate (in particular comprising predominantly copper) which may be patterned, for instance by stamping or etching. Forming the chip carrier as a leadframe is a cost-efficient and mechanically as well as electrically advantageous configuration in which a low ohmic connection of the at least one electronic chip can be combined with a robust support capability of the leadframe. Furthermore, a leadframe may contribute to the thermal conductivity of the package and may remove heat generated during operation of the electronic chip(s) as a result of the high thermal conductivity of the metallic material of the leadframe.

In particular, when such a leadframe comprises or consists of one of the above-mentioned high performance materials, excellent properties in terms of electric and mechanical as well as thermal reliability of the electronic component and long-term maintenance of compressive strain of the semiconductor chip can be obtained.

In another embodiment, the carrier comprises an electrically insulating structure (for instance an electrically insulating layer) and an electrically conductive structure (for instance an electrically conductive layer). In such an embodiment, it is also possible that the carrier not only consists of electrically conductive material meeting two or all three of the above-defined criteria, but additionally comprises an electrically insulating structure providing electric insulation of a main surface of the carrier opposing the electronic chip. In particular, such a carrier may be configured as a double layer structure, wherein one layer is electrically conductive and the other layer is electrically insulating.

In an embodiment, the electrically conductive structure fulfils at least two of the three criteria. Thus, the electrically conductive structure facing the electronic chip and thereby being arranged spatially closest to the electronic chip may be specifically tailored to meet the above-defined design rules.

In an embodiment, the electrically conductive structure is arranged between the electronic chip and the electrically insulating structure. By sandwiching the electrically conductive structure between the electrically insulating structure and the electronic chip, the electronic chip may be positioned closely to the material fulfilling the above-described criteria, whereas an exterior surface of the obtained arrangement may provide a dielectric barrier.

In an embodiment, the carrier additionally comprises a thermally conductive structure (which may be additionally electrically conductive as well), wherein the electrically insulating structure is arranged between the thermally conductive structure and the electrically conductive structure. Such a thermally conductive structure may promote removal of heat out of the electronic component during operation thereof. Thus, the provided carrier not only provides a reliable long-term maintenance of compressive strain of the mounted electronic chip(s), but also provides for a reliable electric isolation and efficient removal of heat.

In an embodiment, the thermally conductive structure fulfils at least two of said three criteria. When also the thermally conductive structure meets two or all three of the above-mentioned criteria, excellent properties in terms of maintenance of compressive strain may be obtained while simultaneously ensuring proper thermal reliability. In particular, the material of the electrically conductive structure and of the thermally conductive structure may be the same. This may keep thermal stress inside of the carrier small.

In an embodiment, a ratio between the offset yield point Rₚ₀₂ of said material at 350°C and the offset yield point Rₚ₀₂ of said material at 100°C (for instance an operating temperature of the electronic component) may be at least 0.75, preferably at least 0.8. It may also be preferred that a ratio between the offset yield point Rₚ₀₂ at 300°C and the offset yield point Rₚ₀₂ at 100°C (for instance an operating temperature of the electronic component) is at least 0.75. In other words, the material may advantageously have low creep properties, i.e. may have only a very low tendency of reducing strain by cooling. This also contributes to the maintenance of compressive strain of the mounted electronic chip over a long-term.

In an embodiment, a ratio between an area of a main surface of the electronic chip (or a sum of multiple main surface areas of multiple electronic chips mounted on the same carrier) and a mounting area of the carrier is at least 50%. When multiple electronic chips are mounted on the same carrier (and in particular on the same main surface and thus same mounting area of the carrier), a sum of the individual areas of a respective main surface of each of the plurality of electronic chips mounted on the carrier divided by the mounting area of the carrier may be at least 50%. When such a large portion of the mounting area of the carrier is occupied by one or more electronic chips, the mechanical forces acting on viscoelastic material (in particular copper based material) of the carrier may be pronounced. With the mentioned material fulfilling at least two of the three above-mentioned criteria in an interface region between carrier and chip, even a highly occupied mounting surface of the carrier may allow keeping one or more semiconductor chips mounted with compressive strain for a long time.

In an embodiment, the method comprises mounting the electronic chip on the carrier at an elevated temperature above an operating temperature of the electronic component. In particular, the electronic chip may be mounted on the carrier at a temperature above 320°C, more particularly at a temperature above 350°C. When the electronic chip is mounted on the carrier at such a high temperature, and subsequently the obtained electronic component is cooled down in a stiffly connected condition of carrier and chip, thermal compression of the electronic chip and the carrier may be significantly different and may consequently intentionally result in the electronic chip being mounted fixedly on the carrier with high compressive strain. This can be achieved by interposing a connection structure between the electronic chip and the carrier.

In an embodiment, the method comprises mounting the electronic chip on the carrier by one of the group consisting of soldering, in particular diffusion soldering, and sintering, in particular sintering using a copper sinter paste and/or a silver sinter paste. Thus, the above-mentioned connection structure may be in particular a solder or sinter material. Soldering and sintering have turned out as powerful connection mechanisms allowing to keep the electronic chip stiffly mounted on the carrier with compressive strain over a long term, in particular over the entire lifetime of the electronic component. However, also a stiff connection formed by welding or a stiff adhesive may be possible.

In an embodiment, the method comprises cold metal forming or hot metal forming of the material, in particular to adjust hardness and tensile strength. Correspondingly, the hardness and high tensile strength of the electronic component may result from cold or hot metal forming.

In an embodiment, at least part of the electronic chip and/or at least part of the carrier may be encapsulated by an encapsulant. In particular, the encapsulant may comprise a mold compound, in particular a plastic mold. For instance, a correspondingly encapsulated body (in particular chip with carrier) may be provided by placing the body or bodies between an upper mold tool and a lower mold tool and to inject liquid mold material therein. After solidification of the mold material, formation of the encapsulant is completed. If desired, the mold may be filled with particles improving its properties, for instance its heat removal properties.

In an embodiment, the carrier may be a leadframe (for instance made of copper), a DAB (Direct Aluminum Bonding), DCB (Direct Copper Bonding) substrate, etc., as long as at least two of the above-mentioned three criteria are fulfilled.

In an embodiment, the electronic component comprises an electrically conductive contact element electrically coupling the electronic chip with the carrier. For instance, the electrically conductive contact element may comprise a clip, a wire bond, and/or a ribbon bond. A clip may be a three-dimensionally bent plate type connection element which has two planar sections to be connected to an upper main surface of the respective electronic chip and an upper main surface of the chip carrier, wherein the two mentioned planar sections are interconnected by a slanted connection section. As an alternative to such a clip, it is possible to use a wire bond or ribbon bond which is a flexible electrically conductive wire or ribbon shaped body having one end portion connected to the upper main surface of the respective chip and having an opposing other end portion being electrically connected to the chip carrier.

In an embodiment, the electronic component is configured as one the group consisting of a leadframe connected power module, a Transistor Outline (TO) electronic component, a Quad Flat No Leads Package (QFN) electronic component, a Small Outline (SO) electronic component, a Small Outline Transistor (SOT) electronic component, and a Thin Small Outline Package (TSOP) electronic component. Therefore, the electronic component according to an exemplary embodiment is fully compatible with standard packaging concepts (in particular fully compatible with standard TO packaging concepts).

In an embodiment, the electronic component is configured as power module, for instance molded power module. For instance, an exemplary embodiment of the electronic component may be an intelligent power module (IPM). Another exemplary embodiment of the electronic component is a dual inline package (DIP).

In an embodiment, the electronic chip is configured as a power semiconductor chip. Thus, the electronic chip (such as a semiconductor chip) may be used for power applications for instance in the automotive field and may for instance have at least one integrated insulated-gate bipolar transistor (IGBT) and/or at least one transistor of another type (such as a MOSFET, a JFET, etc.) and/or at least one integrated diode. Such integrated circuit elements may be made for instance in silicon technology or based on wide-bandgap semiconductors (such as silicon carbide). A semiconductor power chip may comprise one or more field effect transistors, diodes, inverter circuits, half-bridges, full-bridges, drivers, logic circuits, further devices, etc.

In an embodiment, the electronic chip experiences a vertical current flow. The package architecture according to exemplary embodiments is particularly appropriate for high power applications in which a vertical current flow is desired, i.e. a current flow in a direction perpendicular to the two opposing main surfaces of the electronic chip, one of which being used for mounting the electronic chip on the carrier.

As substrate or wafer forming the basis of the electronic chips, a semiconductor substrate, in particular a silicon substrate, may be used. Alternatively, a silicon oxide or another insulator substrate may be provided. It is also possible to implement a germanium substrate or a III-V-semiconductor material. For instance, exemplary embodiments may be implemented in GaN or SiC technology.

Furthermore, exemplary embodiments may make use of standard semiconductor processing technologies such as appropriate etching technologies (including isotropic and anisotropic etching technologies, particularly plasma etching, dry etching, wet etching), patterning technologies (which may involve lithographic masks), deposition technologies (such as chemical vapor deposition (CVD), plasma enhanced chemical vapor deposition (PECVD), atomic layer deposition (ALD), sputtering, etc.).

The above and other objects, features and advantages will become apparent from the following description and the appended claims, taken in conjunction with the accompanying drawings, in which like parts or elements are denoted by like reference numbers.

### Brief description of the drawings

The accompanying drawings, which are included to provide a further understanding of exemplary embodiments and constitute a part of the specification, illustrate exemplary embodiments.

In the drawings:
Figure 1 illustrates a cross-sectional view of an electronic component according to an exemplary embodiment during mounting an electronic chip on a carrier at elevated temperature.
Figure 2 illustrates the electronic component according to Figure 1 after completion of the mounting procedure and after cooling the electronic component to an operation temperature at which the mounted electronic chip maintains compressive strain.
Figure 3 illustrates a cross-sectional view of an electronic component according to another exemplary embodiment to be mounted on a mounting structure.

### Detailed description

The illustration in the drawing is schematically and not to scale.

Before exemplary embodiments will be described in more detail referring to the figures, some general considerations will be summarized based on which exemplary embodiments have been developed.

According to an exemplary embodiment, a carrier (in particular formed on the basis of copper) for a strained silicon device (as an example for an electronic chip) is provided. Stiffly mounting such a strained chip on such a carrier may allow obtaining a highly reliable electronic component, package or module. In this context, usage of the "strained silicon" effect may be advantageous. When the die attach is performed at a high temperature for instance with diffusion soldering, and through a mismatch between the coefficients of thermal expansion (CTE mismatch) of the involved materials as well as through a high temperature difference between mounting temperature and operating temperature, the stiffly mounted die may remain under compressive strain over a wide range of temperatures and operating conditions. This causes an electrically beneficial bandgap narrowing of the material of the electronic chip. According to exemplary embodiments, a particularly appropriate material for the carrier is provided which is appropriate for obtaining the strained silicon effect over a long term by fulfilling a specific combination of design rules, as described below in further detail.

A conventionally mounting MOSFET on a leadframe (which may be denoted as discrete) may have a low ratio of semiconductor to copper area. As such the compressive strain is high for the silicon and overall low for the bulk of copper. As such, relaxation of the copper/semiconductor stack over the operating time can usually be neglected.

However, this may be no longer the case if the ratio of semiconductor to copper area becomes higher. In such cases, the larger surface area and bulk of the semiconductor (s) may exhibit a larger stress on the (in particular isolated) copper or IMS (Insulated Metal Substrate) and may lead to significant undesired relaxation of the metal. This may have the impact that the semiconductors may lose their compressive strain over the lifetime of the module. Especially problematic is that widely used carrier material is pronouncedly pliable in the range between operating temperature and die attach, which leads to losing compressive stress when cooling down from die attach.

In order to at least partly overcome such and/or other shortcomings of conventional approaches, an exemplary embodiment provides an electronic chip (such as a semiconductor die) with compressive strain on the semiconductor using high-performance alloys as metallization part of a chip carrier. Such a chip carrier may be for instance an IMS or a leadframe with however modified material. For instance, such a carrier may be stiffly connected to the electronic chip using diffusion solder, etc.

Advantageously, this may increase the compressive stress, in particular by avoiding or at least suppressing relaxation while cooling down from die attach. Moreover, such an embodiment may allow maintaining compressive strain over the life-time of the electronic component, which may be denoted as low creep behavior. At the same time, it may be possible to realize a high electric conductivity.

A highly appropriate metallization material of the carrier may fulfil at least two of three criteria, and preferably all three of the following criteria:
- High Rₚ₀₂: at least 300 N/mm² (in particular in the range between 100°C and 300°C), preferably at least 500 N/mm²
- High yield strength in the range between 100°C and 300°C: at least 250 N/mm², preferably more than 500 N/mm²
- High electric conductivity: at least 65% IACS, preferably at least 75% IACS.

Particularly appropriate materials meeting these conditions are for example CuZr0.1 or CuCr0.1Zr, but other metals and/or alloys can also be used. In particular CuZrCr and CuZr alloys may have an excellent yield strength in the temperature range from 100°C to 300°C.

Exemplary forms and stackings for providing a carrier of an electronic component according to exemplary embodiments include:
- Bare metal leadframe, in particular made from the above materials, having a coefficient of thermal expansion (CTE) above 10 ppm/K, preferably above 14 ppm/K.
- Sandwich of metal plus an electric isolation layer, with the compound having a CTE value above 10 ppm/K, preferably above 14 ppm/K.
- Sandwich of metal (on the chip side, i.e. facing the electronic chip when mounted) plus an isolation layer plus another metal layer (on a heatsink side, i.e. opposing the electronic chip when mounted), with the compound preferably having a CTE value above 10 ppm/K, preferably above 14 ppm/K (in particular, one or both of the metal components may be made from a high performance alloys as described above, but not necessarily both).

The electronic component may be assembled using a connection structure providing a stiff die attach (for instance diffusion solder, copper sinter paste, silver sinter paste) at a mounting temperature of preferably above 320°C. Then, the electronic component may be cooled down to room temperature. Later, the electronic component may be used at operating temperature, for instance in the range between 50°C and 280°C.

In the assembled device or electronic component, both at room temperature and operating temperature, the semiconductor may be reliably maintained under compressive strain at all times, even for long lifetimes and mission profiles.

In another exemplary embodiment, the electronic component may be treated with other high temperature die attach procedures, preferably with a stiff and non-relaxing interface.

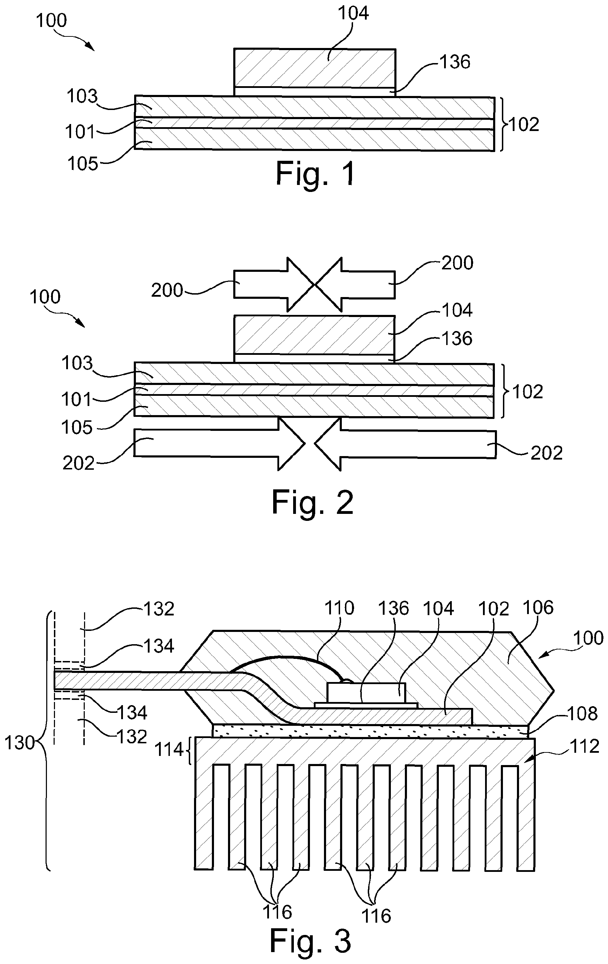

**Figure 1** illustrates a cross-sectional view of an electronic component 100 according to an exemplary embodiment during mounting an electronic chip 104 on a carrier 102 at elevated temperature. **Figure 2** illustrates the electronic component 100 according to Figure 1 after completion of the mounting and after cooling the electronic component 100 to an operation temperature at which the mounted electronic chip 104 maintains compressive strain.

The shown electronic component 100, package or module comprises carrier 102 and electronic chip 104 mounted with compressive strain on the carrier 102. A stiff connection structure 136 is formed at an interface between carrier 102 and electronic chip 104 and may be for example a solder structure (such as a diffusion solder structure) or a sinter structure (such as a sinter structure formed on the basis of copper sinter paste and/or silver sinter paste).

The electronic chip 104 may be a semiconductor die, for instance made of silicon.

In the shown embodiment, the carrier 102 is a layer stack which comprises a central electrically insulating structure 101 and an electrically conductive structure 103 facing the electronic component 104. As shown, the electrically conductive structure 103 is arranged between the electronic chip 104 and the electrically insulating structure 101. Furthermore, the carrier 102 comprises a thermally conductive structure 105. The electrically insulating structure 101 is arranged between the thermally conductive structure 105 and the electrically conductive structure 103.

The electrically insulating structure 101 may be optionally elastic and may preferably have a non-brittle material property. The thermally conductive structure 105 is an optional heat sink metal.

The electrically conductive structure 103 being closest to the electronic chip 104 may be a high performance metal, such as CuZr0.1. Highly advantageously, the material of the electrically conductive structure 103 of the carrier 102 fulfils the following three criteria:
- an offset yield point Rₚ₀₂ at 250°C is at least 500 N/mm²;
- a yield strength at 250°C is at least 500 N/mm²;
- an electrical conductivity at 20°C is at least 75% of the International Annealed Copper Standard IACS.

It is also highly desired that a ratio between the offset yield point Rₚ₀₂ at 350°C and the offset yield point Rₚ₀₂ at 100°C (i.e. a possible operating temperature of the device) is at least 0.75. When such a low creep behavior is present, there is no risk of a significant loss of the compressive strength of the mounted silicon based electronic chip 104 when cooling down from solder temperature to room temperature.

Preferably but not necessarily, also the thermally conductive structure 105 fulfils the mentioned three criteria. For example, the thermally conductive structure 105 may be made of the same material as the electrically conductive structure 103.

Said material meeting the three criteria may be a copper-zirconium alloy, for instance CuZr0.1. Said material may advantageously have an overall coefficient of thermal expansion of larger 14 ppm/K (for instance about 15 ppm/K) at 20°C.

As shown in Figure 1, mounting the electronic chip 104 on the carrier 102 may be done at an elevated temperature preferably above 350°C. Mounting the electronic chip 104 on the carrier 102 may be accomplished by soldering such as diffusion soldering, during which connection structure 136 is formed as a solder structure stiffly connecting carrier 102 with electronic chip 104. It is also possible to perform the mounting by sintering, for instance using a copper sinter paste or a silver sinter paste. As a result of this mounting procedure, the connection structure 136 is formed at an interface between carrier 102 and electronic chip 104.

Figure 1 shows the electronic component 100 in a configuration where die attach is carried out at a temperature above 350°C. In view of the above-described material selection, a stiff and non-relaxing die attach may be carried out, for instance by diffusion soldering.

Now referring to Figure 2, the electronic component 100 is then cooled down, thereby establishing permanent compression strain of the electronic chip 104. This improves the bandwidth properties of the silicon material of the electronic chip 104. Still referring to Figure 2, the obtained electronic component 100 is shown at an operating temperature being significantly below die attach temperature. For instance, operation temperature may be room temperature. In view of the thermal compression of the materials of the electronic chip 104 and the carrier 102, the silicon material of the electronic chip 104 is compressed, as indicated schematically by reference numeral 200. In contrast to this, another compression occurs with the carrier 102, which may preferably have a higher coefficient of thermal expansion. This is indicated schematically by reference numeral 202. Since the silicon material of the electronic chip 104 may have a significantly smaller CTE value (for example about 3 ppm/K compared to about 15 ppm/K of the electrically conductive structure 103), the higher thermal compression forces acting on the carrier 102 will also result in a strong compression of the material of the electronic chip 104. Since the electronic chip 104 is stiffly connected to the carrier 102 due to the stiff connection structure 136, the electronic chip 104 of the electronic component 100 may therefore remain under permanent compressive stress after cooling down to room temperature or operation temperature of the electronic component 100. As a result of the cooling of the electronic component 100 and in view of the different material properties of the electronic chip 104 on the one hand and the carrier 102 on the other hand, the semiconductor material of the electronic chip 104 remains under compressive stress preferably over the entire lifetime of the electronic component 100.

In view of the described material selection, a high electric reliability, mechanical reliability, thermal performance and proper maintenance of the compressive strain of the mounted electronic chip 104 may be synergistically combined. The latter may result, in turn, in low switching losses during operation of the electronic component 100.

Although not shown in Figure 1 and Figure 2, the electronic component 100 may be subsequently encapsulated by an encapsulant (see Figure 3).

**Figure 3** illustrates a cross-sectional view of an electronic component 100, which is embodied as a Transistor Outline (TO) package, according to an exemplary embodiment. The electronic component 100 can be mounted on a mounting structure 132, here embodied as printed circuit board, for establishing an arrangement 130.

The mounting structure 132 comprises an electric contact 134 embodied as a plating in a through hole of the mounting structure 132. When the electronic component 100 is mounted on the mounting structure 132, electronic chip 104 of the electronic component 100 is electrically connected to the electric contact 134 via electrically conductive carrier 102, here embodied as a leadframe made of a material meeting the three above-mentioned criteria, of the electronic component 100.

The electronic component 100 thus comprises the electrically conductive carrier 102, the electronic chip 104 (which is here embodied as a power semiconductor chip) stiffly mounted on the carrier 102 by solder or sinter contact structure 136, and an encapsulant in form of a mold compound 106 encapsulating part of the carrier 102 and part of the electronic chip 104. As can be taken from Figure 3, a pad on an upper main surface of the electronic chip 104 is electrically coupled to the carrier 102 via a bond wire as electrically conductive contact element 110.

During operation of the power package or electronic component 100, the power semiconductor chip in form of the electronic chip 104 generates a considerable amount of heat. At the same time, it shall be ensured that any undesired current flow between a bottom surface of the electronic component 100 and an environment is reliably avoided.

For ensuring electrical insulation of the electronic chip 104 and removing heat from an interior of the electronic chip 104 towards an environment, an electrically insulating and thermally conductive interface structure 108 may be provided which covers an exposed surface portion of the carrier 102 and a connected surface portion of the mold compound 106 at the bottom of the electronic component 100. The electrically insulating property of the interface structure 108 prevents undesired current flow even in the presence of high voltages between an interior and an exterior of the electronic component 100. The thermally conductive property of the interface structure 108 promotes a removal of heat from the electronic chip 104, via the electrically conductive carrier 102, through the interface structure 108 and towards a heat dissipation body 112. The heat dissipation body 112, which may be made of a highly thermally conductive material such as copper or aluminum, has a base body 114 directly connected to the interface structure 108 and has a plurality of cooling fins 116 extending from the base body 114 and in parallel to one another so as to remove the heat towards the environment.

It should be noted that the term "comprising" does not exclude other elements or features and the "a" or "an" does not exclude a plurality. Also elements described in association with different embodiments may be combined. It should also be noted that reference signs shall not be construed as limiting the scope of the claims. Moreover, the scope of the present application is not intended to be limited to the particular embodiments of the process, machine, manufacture, composition of matter, means, methods and steps described in the specification. Accordingly, the appended claims are intended to include within their scope such processes, machines, manufacture, compositions of matter, means, methods, or steps.

## Claims

1. An electronic component (100), the electronic component (100) comprising:
• a carrier (102);
• an electronic chip (104) mounted with compressive strain on the carrier (102);
• wherein at least a part of a material of the carrier (102) fulfils at least two of the following three criteria:
∘ an offset yield point Rₚ₀₂ in a range between 100°C and 300°C is at least 300 N/mm²;
∘ a yield strength in a range between 100°C and 300°C is at least 250 N/mm²
∘ an electrical conductivity at 20°C is at least 65% of the International Annealed Copper Standard IACS.

2. The electronic component (100) according to claim 1, comprising at least one of the following features:
• wherein the offset yield point Rₚ₀₂ in a range between 100°C and 300°C is at least 500 N/mm²;
• wherein the yield strength in a range between 100°C and 300°C is at least 500 N/mm²;
• wherein the electrical conductivity at 20°C is at least 75% of the International Annealed Copper Standard IACS;
• wherein a ratio between the offset yield point Rₚ₀₂ at 350°C and the offset yield point Rₚ₀₂ at 100°C is at least 0.75.

3. The electronic component (100) according to claim 1 or 2, wherein a ratio between the offset yield point Rₚ₀₂ at 300°C and the offset yield point Rₚ₀₂ at 100°C is at least 0.75.

4. The electronic component (100) according to any of claims 1 to 3, wherein the material comprises or consists of at least one of the group consisting of a metal and an alloy.

5. The electronic component (100) according to any of claims 1 to 4, wherein the material comprises or consists of an alloy of copper with not more than one weight percent of at least one other metal in relation to the copper and the at least one other metal, in particular at least one of zirconium, chromium, silver and zinc.

6. The electronic component (100) according to any of claims 1 to 5, wherein the material comprises or consists of a copper-X alloy, in particular comprises or consists of primarily copper and up to 1 weight percent of X, X being a sum of zirconium, chromium, silver and zinc.

7. The electronic component (100) according to any of claims 1 to 6, wherein the material of the carrier (102) has an overall coefficient of thermal expansion of larger than 10 ppm/K, in particular larger than 14 ppm/K.

8. The electronic component (100) according to any of claims 1 to 7, wherein the carrier (102) is a bare metal body.

9. The electronic component (100) according to any of claims 1 to 8, wherein the carrier (102) is a leadframe, in particular a bare metal leadframe.

10. The electronic component (100) according to any of claims 1 to 7, wherein the carrier (102) comprises an electrically insulating structure (101) and an electrically conductive structure (103).

11. The electronic component (100) according to claim 10, comprising at least one of the following features:
• wherein the electrically conductive structure (103) fulfils at least two of the three criteria;
• wherein the electrically conductive structure (103) is arranged between the electronic chip (104) and the electrically insulating structure (101).

12. The electronic component (100) according to claim 10 or 11, wherein the carrier (102) comprises a thermally conductive structure (105), wherein the electrically insulating structure (101) is arranged between the thermally conductive structure (105) and the electrically conductive structure (103), wherein in particular the thermally conductive structure (105) fulfils at least two of the three criteria.

13. The electronic component (100) according to any of claims 1 to 12, wherein a ratio between an area of a main surface of the electronic chip (104), or a sum of areas of a main surface of a plurality of electronic chips (104) mounted on the carrier (102), and a mounting area of the carrier (102) is at least 50%.

14. A method of manufacturing an electronic component (100), the method comprising:
• mounting an electronic chip (104) with compressive strain on a carrier (102);
• providing at least a part of a material of the carrier (102) so as to fulfil at least two of the following three criteria:
o an offset yield point Rₚ₀₂ in a range between 100°C and 300°C is at least 300 N/mm²;
o a yield strength in a range between 100°C and 300°C is at least 250 N/mm²;
o an electrical conductivity at 20°C is at least 65% of the International Annealed Copper Standard IACS.

15. The method according to claim 14, comprising at least one of the following features:
• wherein the method comprises mounting the electronic chip (104) on the carrier (102) at a mounting temperature above an operating temperature, in particular at a temperature above 300°C, more particularly at a temperature above 350°C;
• wherein the method comprises mounting the electronic chip (104) on the carrier (102) by one of the group consisting of soldering, in particular diffusion soldering, and sintering, in particular sintering using a copper sinter paste and/or a silver sinter paste;
• wherein the method comprises cold metal forming or hot metal forming of said material, in particular to adjust hardness and tensile strength.

## Amended claims

### Amended claims in accordance with Rule 137(2) EPC.

1. An electronic component (100), the electronic component (100) comprising:
• a carrier (102);
• an electronic chip (104) mounted with compressive strain on the carrier (102);
• wherein at least a part of a material of the carrier (102) fulfils at least two of the following three criteria:
∘ an offset yield point Rₚ₀₂ in a range between 100°C and 300°C is at least 300 N/mm²;
∘ a yield strength in a range between 100°C and 300°C is at least 250 N/mm²
∘ an electrical conductivity at 20°C is at least 65% of the International Annealed Copper Standard IACS,
this part consisting of a binary or trinary alloy of copper with not more than one weight percent of at least one of zirconium, chromium, silver and zinc in relation to the copper and the at least one other metal or of an alloy selected from the group consisting of CuMg0.1, CuFe0.1 and CuSn0.15.

2. The electronic component (100) according to claim 1, comprising at least one of the following features:
• wherein the offset yield point Rₚ₀₂ in a range between 100°C and 300°C is at least 500 N/mm²;
• wherein the yield strength in a range between 100°C and 300°C is at least 500 N/mm²;
• wherein the electrical conductivity at 20°C is at least 75% of the International Annealed Copper Standard IACS.

3. The electronic component (100) according to claim 1 or 2, wherein this part of the material consists of a copper-X alloy, in particular comprises or consists of primarily copper and up to 1 weight percent of X, X being the sum of zirconium, chromium, silver and zinc.

4. The electronic component (100) according to any of claims 1 to 3, wherein this part of the material of the carrier (102) has an overall coefficient of thermal expansion of larger than 10 ppm/K, in particular larger than 14 ppm/K.

5. The electronic component (100) according to any of claims 1 to 4, wherein the carrier (102) is a bare metal body.

6. The electronic component (100) according to any of claims 1 to 5, wherein the carrier (102) is a leadframe, in particular a bare metal leadframe.

7. The electronic component (100) according to any of claims 1 to 4, wherein the carrier (102) comprises an electrically insulating structure (101) and an electrically conductive structure (103).

8. The electronic component (100) according to claim 7, comprising at least one of the following features:
• wherein the electrically conductive structure (103) fulfils at least two of the three criteria;
• wherein the electrically conductive structure (103) is arranged between the electronic chip (104) and the electrically insulating structure (101).

9. The electronic component (100) according to claim 7 or 8, wherein the carrier (102) comprises a thermally conductive structure (105), wherein the electrically insulating structure (101) is arranged between the thermally conductive structure (105) and the electrically conductive structure (103), wherein in particular the thermally conductive structure (105) fulfils at least two of the three criteria.

10. The electronic component (100) according to any of claims 1 to 9, wherein a ratio between an area of a main surface of the electronic chip (104), or a sum of areas of a main surface of a plurality of electronic chips (104) mounted on the carrier (102), and a mounting area of the carrier (102) is at least 50%.

11. A method of manufacturing an electronic component (100), the method comprising:
• mounting an electronic chip (104) with compressive strain on a carrier (102) at a mounting temperature of at least 300°C;
• providing at least a part of a material of the carrier (102) so as to fulfil at least two of the following three criteria:
∘ an offset yield point Rₚ₀₂ in a range between 100 °C and 300°C is at least 300 N/mm²;
∘ a yield strength in a range between 100°C and 300°C is at least 250 N/mm²;
∘ an electrical conductivity at 20°C is at least 65% of the International Annealed Copper Standard IACS.

12. The method according to claim 11, comprising at least one of the following features:
• wherein the method comprises mounting the electronic chip (104) on the carrier (102) at a mounting temperature above 350°C;
• wherein the method comprises mounting the electronic chip (104) on the carrier (102) by one of the group consisting of soldering, in particular diffusion soldering, and sintering, in particular sintering using a copper sinter paste and/or a silver sinter paste;
• wherein the method comprises cold metal forming or hot metal forming of said material, in particular to adjust hardness and tensile strength.
